Europäisches Patentamt

European Patent Office

Office européen des brevets

(11) Publication number: **0 281 989**

**A1**

## EUROPEAN PATENT APPLICATION

(21) Application number: 88103545.5

(22) Date of filing: 08.03.88

(51) Int. Cl.4: **H01L 31/02** , G02B 6/42 , G02B 6/12

(30) Priority: 11.03.87 US 24443

(43) Date of publication of application:
14.09.88 Bulletin 88/37

(84) Designated Contracting States:
DE FR GB

(71) Applicant: HONEYWELL INC.
Honeywell Plaza
Minneapolis Minnesota 55440(US)

(72) Inventor: Arnold, Steven M.
5929 Dupont Avenue South
Minneapolis Minnesota 55419(US)

(74) Representative: Rentzsch, Heinz et al
Honeywell Europe S.A. Holding KG Patent-
und Lizenzabteilung Kaiserleistrasse 55
D-6050 Offenbach am Main(DE)

(54) Channel waveguide Schottky photodiode.

(57) A channel waveguide Schottky photodiode com-
prises a silicon dioxide (11) covered substrate of
gallium arsenide (10). A thin film waveguide (12) of
zinc oxide having a thickened rib (15) to delineate
the waveguide path (20, 21, 22) is deposited on the
silicon dioxide (11). To couple light from the
waveguide (12) to the gallium arsenide (10), an
opening (31) or at least a thinned portion (16) was
provided in the silicon dioxide (11) before the ZnO
was deposited, so that the ribbed area (15) of the
ZnO makes direct contact with the gallium arsenide
(10). On either side of this direct contact a metal
electrode (31, 32) is also in direct contact with the
gallium arsenide forming narrowly spaced Schottky
diodes.

Fig. 2

Fig. 3

# CHANNEL WAVEGUIDE SCHOTTKY PHOTODIODE

The field of the invention is integrated optoelectronic circuits and particularly an integrated photodetector. The present invention is directed to an easily fabricated, sensitive high-speed photodiode, and a means of coupling light from a channel waveguide to this photodiode. In a preferred embodiment the approach to IC-compatible optoelectronic integration uses thin film waveguides of zinc oxide on substrates of gallium arsenide. The invention is characterized in claim 1 and preferred embodiments are described in the subclaims.

The unique feature of the proposed detector is that it uses two parallel electrodes with the channel waveguide passing between them. This invention has three advantages over previous Schottky photodiodes using interdigitated electrode patterns. First, the electrodes aid in confining the light to the channel while not, themselves, contributing significant absorption. Second, the narrow interelectrode gap and small electrode size result in a very high-speed detector. Third, by introducing a thin buffer layer between the photodiode and the wave guiding layer, it is relatively easy to make a leaky-waveguide photodetector to tap only a portion of the guided light.

## BRIEF DESCRIPTION OF THE DRAWINGS

Figure 1 shows generally a thin-film waveguide structure.

Figure 2 shows an integrated waveguide photo-detector.

Figures 3 and 4 are a top view and a section view of a preferred embodiment of the invention.

## DESCRIPTION OF THE DRAWINGS

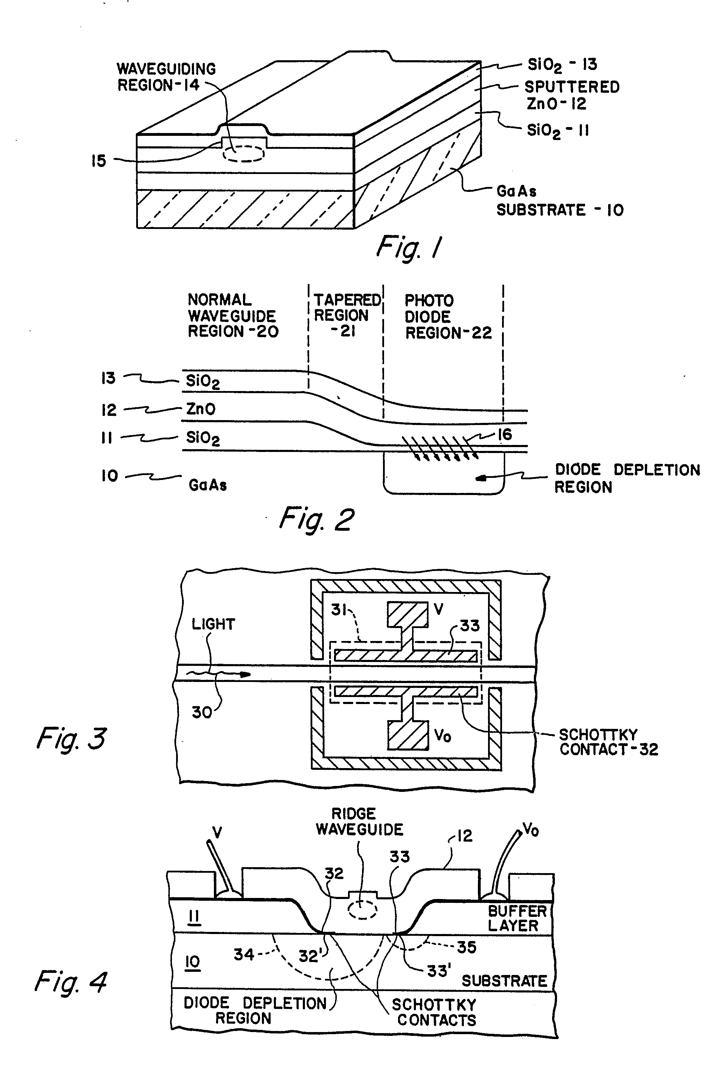

Figure 1 shows a basic thin-film channel waveguide structure. On a gallium arsenide substrate 10 is formed a layer of silicon dioxide 11, followed by a thin-film layer of sputtered zinc oxide 12. Zinc oxide is a unique thin-film waveguide material. Sputter deposited ZnO films are polycrystalline with the c-axis oriented normal to the substrate. ZnO has sizeable piezoelectric, electrooptic, and nonlinear optical coefficients, making it possible to fabricate surface acoustic wave (SAW) and active optical devices in the same film. Waveguides of ZnO can have very low optical losses, with values as low as 0.01 dB/cm having been reported for laser annealed planar films on oxidized silicon. A passivating layer of silicon dioxide 13 is over the ZnO and also provides a symmetric mode structure.

Light is confined to the ZnO film which is sandwiched between the two lower index layers of SiO₂. For single mode operation, the thickness of the ZnO layer is about 0.3 micron while the lower SiO₂ (buffer) layer must be 1.0 micron or more to minimize coupling to the higher index substrate. A waveguiding region 14 is shown at an area 15 of thicker ZnO. Vertical confinement is provided by the planar SiO₂-ZnO-SiO₂ structure and the lateral confinement is at the ridge structure 15 (thicker ZnO channel region) which has a locally increased effective refractive index.

Various combinations of ridge height and width will result in single mode waveguides, but a width of 2.5 microns and a height of about 100A° provide a good compromise between ease of fabrication an acceptable bending losses. Since the ridge height is rather small, scattering due to sidewall roughness can be minimal.

One of the strengths of the thin-film ZnO on GaAs approach to optoelectronic circuits is that Schottky diode photodetectors can be easily fabricated in the GaAs substrate. Figure 2 depicts how light may be coupled from a waveguide to such a detector. The figure shows a normal waveguide region 20, an optional tapered region 21 and a photodiode region 22. The gradual thinning of the lower silicon dioxide layer 11 in the tapered region 21 leads to a thinned area or an opening in the SiO₂ buffer layer. Optimal coupling requires tapering of the buffer layer to prevent the back reflections which result from an abrupt discontinuity. Waveguide-to-detector coupling occurs through the thinned area or opening in the buffer layer. Thus light in the waveguide is coupled at 16 to the high index GaAs substrate 10.

A Schottky diode results when a metal is placed directly on a wide-bandgap semiconductor substrate material such as semi-insulating GaAs. A portion of the semiconductor beneath the metal contact is depleted of carriers, the extent of the depletion region depending on the applied bias voltage.

In the present invention the Schottky photodiode consists of two back-to-back Schottky diodes. Thus in Figures 3 and 4 there is shown a top view and a section view of the integrated device. Referring to Figure 3, there is shown a waveguide 30 extending across the thin-film structure. A dotted rectangle 31 defines the boundary of the opening in the buffer layer 11. That is, the buffer layer is omitted in the detector region, the waveguiding layer 12 follows the contour and drops down to the substrate 10 allowing guided light to couple to the higher index substrate. Elements 32 and 33 are the Schottky diode contacts which contact the substrate. The channel waveguide 30 consists of a waveguiding layer 12 separated from the substrate 10 by a lower index buffer layer 11. The waveguiding and buffer layers are deposited thin films (e.g., ZnO on $SiO_2$ on GaAs). Lateral optical confinement is provided by a ridge structure or else by parallel strips of metal deposited on top of the waveguiding layer.

In Figure 4 metal elements 32 and 33 are shown more clearly in direct contact with the wide bandgap substrate 10 to form the Schottky diodes. Beneath these contacts 32′ and 33′ is shown dashed-line curves 34 and 35 which define diode depletion regions in the GaAs substrate. It should be noted that the drawings are not drawn to scale. Particularly, the several layers of Figure 4 are greatly enlarged for explanatory purposes. The thickness of the metal contact layer may be about 40 angstroms. Generally, the substrate layer thickness is greater than that of waveguiding layer 12 and buffer layer 11. The distance between contacts 32 and 33 is in the range of 3-8µm.

Under illumination by the channel waveguide, photocarriers are generated in the portion of the substrate underlying the waveguide and corresponding to the diode depletion region. The photocurrent increases with increasing bias voltage and with increasing illumination. A typical bias may be in the order of 20 volts.

## Claims

1. A channel waveguide Schottky photodiode **characterized by**

    a) a semi-insulating substrate (10) having a planar surface;

    b) a pair of elongated metal electrodes (32, 33) each making Schottky contact with said substrate (10), said elongated electrodes being positioned to be spaced from one another and parallel to each other, the area between said electrodes being called an elongated electrodes area;

    c) a thin film buffer layer (11) of a dielectric deposited over said substrate (10) surface;

    d) a waveguiding thin film layer (12) deposited over said buffer layer (11) and said elongated electrodes area, whereby said waveguiding layer (12) overlies said substrate (10) surface at said elongated electrodes area between said pair of Schottky contacts said waveguiding thin film layer having a portion defining a waveguide path (21), said path directed between said electrodes (32, 33);

    e) said dielectric buffer layer (11) being arranged to allow optical coupling (16) from said waveguiding layer (12) into said substrate (10) at said elongated electrodes area, so that light being transmitted along said waveguide upon reaching said elongated electrodes area is coupled from the waveguide into said substrate and the resulting photocarriers generated in the portion of the substrate underlying the waveguide results in a current in said Schottky diodes when a bias voltage is applied therebetween.

2. Photodiode according to claim 1, **characterized in that** the waveguiding thin film layer (12) has a thickened ridge (15) extending therealong to define the waveguide path (20, 21, 22).

3. The photodiode according to claim 1 or 2, **characterized in that,** said thin-film buffer layer (11) is arranged to have a thinned region (22) between said pair of elongated metal electrodes (32, 33) to permit the optical coupling to the substrate (10).

4. The photodiode according to claim 3, **characterized in that** the thinned region (22) is an opening (31) through the buffer layer (11) to allow contact of said waveguide layer (12) with said substrate (10) at a location between said elongated electrodes (32, 33).

5. The photodiode according to claim 3 or 4, **characterized in that** the buffer layer (11) comprises a tapered region (21) between the normal waveguide region (20) of said waveguide layer (12) and said optical coupling region (22).

6. The photodiode according to one of the preceding claims, **characterized in that** said semi-insulating substrate (10) is gallium arsenide GaAs.

7. The photodiode according to one of the preceding claims, **characterized in that** thin film buffer layer (11) is silicon dioxide $SiO_2$.

8. The photodiode according to one of the preceding claims, **characterized in that** the waveguide layer (12) has higher refractive index than said buffer layer (11).

9. The photodiode according to claim 8, **characterized in that** the waveguiding thin film layer (12) is zinc oxide Zno

10. The photodiode according to one of the preceding claims, **characterized in that** the parallel elongated metal electrodes (32, 33) are spaced from one another by a distance in the range of 3 to 8 µm.

11. The photodiode according to one of the preceding claims, **characterized in that** the waveguiding thin film layer (12) is about 0.3 micron in thickness.

12. The photodiode according to claims 2 and 11, **characterized in that** the width of the ridge (15) is about 2,5 μm and its height is about 100 Angstroms.

13. The photodiode according to one of the preceding claims, **characterized in that** the thin film buffer layer (11) outside the coupling region (22) has a thickness of at least 1.0 μm.

14. The photodiode according to claims 6 and 7, **characterized in that** the thin-film buffer layer (11) of silicon dioxide has a lower bandgap than said gallium arsenide substrate (10).

WAVEGUIDING REGION-14

SiO₂ - 13

SPUTTERED ZnO-12

SiO₂ - 11

15

GaAs SUBSTRATE - 10

*Fig. 1*

| NORMAL WAVEGUIDE REGION -20 | TAPERED REGION -21 | PHOTO DIODE REGION-22 |

13 — SiO₂

12 — ZnO

11 — SiO₂

10 — GaAs

16

DIODE DEPLETION REGION

*Fig. 2*

LIGHT

31

V

33

30

Vo

SCHOTTKY CONTACT-32

*Fig. 3*

V

RIDGE WAVEGUIDE

32

33

12

Vo

BUFFER LAYER

11

10

34

32'

33'

35

SUBSTRATE

DIODE DEPLETION REGION

SCHOTTKY CONTACTS

*Fig. 4*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | APPLIED OPTICS, vol. 15, no. 6, June 1979, page 1389; J.J. BOYD et al.: "Integrated optical silicon photodiode array" <br> * figures 1a, 1b; page 1389, column 2, paragraph 2 * | 1,3,5,7,8 | H 01 L 31/02 <br> G 02 B 6/42 <br> G 02 B 6/12 |
| A | PATENT ABSTRACTS OF JAPAN, vol. 7, no. 18 (P-170)[1163], 25th January 1983; & JP - A - 57 173 804 (MATSUSHITA DENKI) 26-10-1982 <br> * figure, abstract * | 1,6-9 | |
| A | PATENT ABSTRACTS OF JAPAN, vol. 9, no. 281 (P-403)[2004], 8th November 1985; & JP - A - 60 123 806 (MATSUSHITA DENKI) 02-07-1985 <br> * figure, abstract * | 1,10 | |
| A | US-A-4 636 646 (D.T. HARTMAN et al.) <br> * abstract; figure 4, column 2, lines 34-66 * | 1,2 | TECHNICAL FIELDS SEARCHED (Int. Cl.4) |
| A | APPLIED OPTICS LETTERS, vol. 26, no. 11, 1st June 1975, pages 632-635, New York, US; C.C. TSENG et al.: "Integrated grating-type Schottky barrier photodetector with optical channel waveguide" <br> * abstract, figure 2a * | 1 | H 01 L <br> G 02 B <br> H 04 B |

The present search report has been drawn up for all claims

| Place of search | Date of completion of the search | Examiner |
|---|---|---|
| BERLIN | 20-04-1988 | JUHL A. |